# EUROPEAN PATENT SPECIFICATION

(11) **EP 3 991 855 B1**
(45) Date of publication and mention of the grant of the patent: **18.10.2023**
(21) Application number: 19935282.4
(22) Date of filing: 31.12.2019
(51) Int. Cl.: B05C 11/10, B05C 5/02, B05B 12/08, G05D 16/00, H01L 23/00, G05D 7/06

(54) **GLUE DISPENSING CONTROL APPARATUS AND GLUE OUTLET CONTROL METHOD THEREFOR**
VORRICHTUNG ZUR STEUERUNG DER LEIMAUSGABE UND LEIMAUSGABESTEUERVERFAHREN DAFÜR
APPAREIL DE COMMANDE DE DISTRIBUTION DE COLLE ET PROCÉDÉ DE COMMANDE D'ÉCOULEMENT DE COLLE CORRESPONDANT

(30) Priority: 25.06.2019 CN 201910555990; 25.06.2019 CN 201910557123
(43) Date of publication of application: 04.05.2022
(73) Proprietor: Changzhou Mingseal Robot Technology Co., Ltd., Jiangsu 213164 (CN)
(72) Inventor: ZHANG, Jin, Changzhou, Jiangsu 213164 (CN); SUN, Pei, Changzhou, Jiangsu 213164 (CN); QU, Dongsheng, Changzhou, Jiangsu 213164 (CN); ZHAO, Yajun, Changzhou, Jiangsu 213164 (CN)
(74) Representative: Rösler Rasch van der Heide & Partner
(86) International application number: PCT/CN2019/130259
(87) International publication number: WO 2020/258815

(56) References cited:
- CN-A- 1 431 134
- CN-A- 103 721 893
- CN-A- 104 280 090
- CN-A- 106 423 754
- CN-A- 110 102 443
- CN-A- 110 170 426
- CN-A- 110 170 426
- CN-U- 204 583 600
- JP-A- 2006 192 371
- JP-A- 2014 108 414
- US-A- 4 874 444
- US-A1- 2008 210 706
- US-A1- 2012 104 033
- US-B2- 8 505 566

## Description

### TECHNICAL FIELD

The present disclosure relates to the technical field of dispensing, and more particularly, to a dispensing control apparatus and a glue discharging control method thereof.

### BACKGROUND

The conventional pneumatic dispensing controller is internally provided with an analog barometer, a digital barometer or a gas pressure sensor which is connected to a pipeline between a gas outlet of a first pressure reducing device and a gas inlet of a first exhaust valve. The analog barometer, the digital barometer or the gas pressure sensor is configured to measure and display a set gas pressure, but cannot monitor the gas pressure waveform in a pipeline of a glue barrel, and thus does not have a function of monitoring the gas pressure in the glue barrel.

According to a specific dispensing process, dispensing parameters are determined when the glue barrel is full of glue, and with an increase of glue discharging times, a residual amount of glue in the glue barrel is gradually reduced, and a glue discharging amount is reduced accordingly. When the glue discharging is significantly reduced to be lower than the glue amount requirement, an operator is required to change the dispensing parameters (generally, properly increasing a glue discharging duration). The core problems of the dispensing application lie in that, firstly, since the dispensing parameters need to be changed for many times by the operator, it is needed to test and verify the glue amount to check whether the changed parameters are appropriate; and secondly, the glue discharging amount will obviously fluctuate due to the dispensing parameters being changed by the operating personnel for many times, that is, the dispensing parameters are changed suddenly when the glue discharging amount is obviously reduced, resulting in that the next glue discharging amount may be increased significantly.

In conclusion, the dispensing operation requires the operator to adjust the parameters for many times, and the dispensing consistency is difficult to be improved. When the residual amount of the glue is gradually reduced until no glue is left, no glue spot may appear suddenly, which causes abnormal dispensing procedures on an automatic dispensing apparatus or production line and directly affects the whole process. CN104280090A provides a measuring and detecting method and device for glue valve residual glue liquid. US2012104033A1 provides a dispenser and method for dispensing a liquid.

### SUMMARY

The present disclosure aims to at least solve one of the technical problems in the related art.

The disclosure provides a dispensing control apparatus, which can achieve a self-adaptive adjustment of dispensing parameters, a function of alarming a residual amount of glue solution being insufficient, and self-adaptive feedback control of a suck-back gas pressure.

The disclosure further provides a control method for the dispensing control apparatus.

According to the first aspect embodiments of the disclosure, the dispensing control apparatus includes a machine body provided with a first input interface adapted to be connected to a gas source, a first output interface adapted to be connected to an external glue barrel, and a second output interface; a first pressure reducing device arranged in the machine body and including a gas inlet end connected to the first input interface; a first exhaust valve arranged in the machine body and including a gas inlet connected to a gas outlet end of the first pressure reducing device; a second exhaust valve including an inlet connected to a gas outlet of the first exhaust valve and the first output interface, and an outlet connected to the second output interface; a first gas pressure sensor arranged between the gas outlet of the first exhaust valve and the first output interface and configured to acquire a real-time gas pressure in a pipeline connected between the first exhaust valve and the first output interface; and a control device arranged in the machine body and electrically connected to the first pressure reducing device, the first exhaust valve, the second exhaust valve and the first gas pressure sensor, wherein the control device is configured to control the first pressure reducing device, the first exhaust valve, the second exhaust valve and the first gas pressure sensor, and the control device is further configured to continuously receive the real-time gas pressure acquired by the first gas pressure sensor, process the real-time gas pressure in real time and extract a characteristic parameter of gas pressure increasing.

According to some embodiments of the present disclosure, the machine body is further provided with a third output interface, and the dispensing control apparatus further includes a suck-back gas pressure generating device including: a second pressure reducing device including a gas inlet connected to the first input interface; and a vacuum generator including a vacuum generating port connected to the gas outlet of the first exhaust valve, a gas inlet connected to a gas outlet of the second pressure reducing device, and a gas outlet connected to the third output interface.

According to some embodiments of the present disclosure, the pipeline connecting the vacuum generating port of the vacuum generator with the gas outlet of the first exhaust valve is a gas suction port of the suck-back gas pressure generating device, and the dispensing control apparatus further includes: a second gas pressure sensor connected to the gas suction port of the suck-back gas pressure generating device and configured to acquire a suck-back gas pressure generated by the suck-back gas pressure generating device, wherein the second gas pressure sensor is electrically connected to the control device, and the control device is further configured to continuously receive signals acquired by the second gas pressure sensor.

According to some embodiments of the present disclosure, the second pressure reducing device is an electric proportional valve or an electric air pressure reducing valve.

According to some embodiments of the present disclosure, the first pressure reducing device is a precise pressure reducing valve, an electric proportional valve or an electric air pressure reducing valve; and /or at least one of the first exhaust valve and the second exhaust valve is a two-position three-way electromagnetic valve, and a flow rate of the second exhaust valve is greater than that of the first exhaust valve.

According to some embodiments of the present disclosure, the first pressure reducing device includes: a first pressure reducing valve at least including a gas inlet forming the gas inlet end of the first pressure reducing device, and a gas outlet connected to the gas inlet of the first exhaust valve.

According to some embodiments of the present disclosure, the first pressure reducing device further includes: a special-shaped pipe joint internally provided with a pipe cavity penetrating therethrough along an axial direction of the special-shaped pipe joint, wherein an outer surface of the special-shaped pipe joint is provided with one or more gas flow channels in communication with the pipe cavity, and the special-shaped pipe joint is connected between the gas outlet of the first pressure reducing valve and the gas inlet of the first exhaust valve.

According to some embodiments of the present disclosure, the gas flow channel has a minimum diameter smaller than or equal to 1mm, or a minimum cross-sectional area smaller than or equal to 1mm².

According to some embodiments of the present disclosure, the dispensing control apparatus further includes: a gas storage tank located between the special-shaped pipe joint and the first exhaust valve and in communication therewith.

According to some embodiments of the present disclosure, the dispensing control apparatus further includes: a speed control valve located between the special-shaped pipe joint and the first exhaust valve and in communication therewith, and configured to adjust a maximum flow output by the first pressure reducing device.

According to some embodiments of the present disclosure, the dispensing control apparatus further includes: a variable-diameter pipe located between the special-shaped pipe joint and the gas storage tank and in communication therewith.

A glue discharging control method according to some embodiments of the second aspect of the disclosure adopts the dispensing control apparatus according to some embodiments of the first aspect of the disclosure. The glue discharging control method includes:
step S1of setting a working gas pressure, a suck-back gas pressure and a glue discharging duration;
step S2 of presetting a first gas pressure waveform when an empty glue barrel is connected to the first output interface, and a second gas pressure waveform when a full glue barrel is connected to the first output interface;
step S3 of presetting a residual amount alarm threshold;
step S4 of determining whether the first output interface is connected to a glue barrel to be subjected to dispensing, and whether a dispensing trigger signal is received;
step S5 of in response to the dispensing trigger signal being received, outputting the working gas pressure, detecting the real-time gas pressure waveform acquired by the first gas pressure sensor in real time within the glue discharging duration, and predicting a residual amount of glue in the glue barrel based on the real-time gas pressure waveform, the first gas pressure waveform and the second gas pressure waveform;
step S6 of adjusting the working gas pressure, the suck-back gas pressure and the glue discharging duration in the step S1 based on the residual amount of glue, and returning to the step S5; and
step S7 of sending an alarm signal, stopping glue discharging and returning to the step S4, when the residual amount of the glue in the step S5 is smaller than the residual amount alarm threshold.

According to some embodiments of the present disclosure, in the step S2, detecting each of the first gas pressure waveform and the second gas pressure waveform includes:
step S21 of detecting whether the first output interface is connected to the glue barrel to be detected, and whether an execution signal is received;
step S22 of enabling the first gas pressure sensor to acquire gas pressure waveforms within a preset detection time after receiving the execution signal; and
step S23 of storing the corresponding gas pressure waveforms.

Additional aspects and advantages of the present disclosure will be set forth in part in the following description which follows, and some will become obvious from the following description or learned through practice of the present disclosure.

### BRIEF DESCRIPTION OF DRAWINGS

The above and/or additional aspects and advantages of the present disclosure will become apparent and readily appreciated from the following description of embodiments, taken in conjunction with the accompanying drawings, in which:
FIG. 1 is a schematic view of a dispensing control apparatus according to an embodiment of the present disclosure;
FIG. 2 is a schematic view of a first pressure reducing device of a dispensing control apparatus according to a first embodiment of the present disclosure;
FIG. 3a is a schematic view of a first pressure reducing device of a dispensing control apparatus according to a second embodiment of the present disclosure;
FIG. 3b is a schematic view of a special-shaped pipe joint in the first pressure reducing device of FIG. 3a;
FIG. 4 is a schematic view of a first pressure reducing device of a dispensing control apparatus according to a third embodiment of the present disclosure;
FIG. 5 is a schematic view of a first pressure reducing device of a dispensing control apparatus according to a fourth embodiment of the present disclosure;
FIG. 6 is a schematic view of a first pressure reducing device of a dispensing control apparatus according to a fifth embodiment of the present disclosure;
FIG. 7 is a schematic view of a first pressure reducing device of a dispensing control apparatus according to a sixth embodiment of the present disclosure;
FIG. 8 is a schematic view of a first pressure reducing device of a dispensing control apparatus according to a seventh embodiment of the present disclosure;
FIG. 9 is a schematic view of a first pressure reducing device of a dispensing control apparatus according to an eighth embodiment of the present disclosure;
FIG 10 is a flowchart of a glue discharging control method of a dispensing control apparatus according to an embodiment of the present disclosure;
FIG. 11 is a flow chart of detecting a first or second gas pressure waveform in Fig. 10; and
FIG. 12 is an explanatory diagram illustrating an operation of a dispensing control apparatus according to an embodiment of the present disclosure.

### DESCRIPTION OF EMBODIMENTS

The embodiments of the present disclosure will be described in detail below, and examples of the embodiments are illustrated in the accompanying drawings, in which the same or similar reference numerals refer to the same or similar elements or elements having the same or similar functions throughout. The embodiments described below with reference to the accompanying drawings are illustrative and intended to explain the present disclosure, and shall not be construed as limiting the present disclosure.

In the description of the present disclosure, it is to be understood that the terms "center", "up", "down", "front", "rear", "left", "right", "vertical", "horizontal", "top", "bottom", "in", "out", etc. indicate orientations or positional relationships based on those shown in the drawings, and are only for convenience and simplicity of description, but do not indicate or imply that the devices or elements referred to must have particular orientations, be constructed and operated in particular orientations, and thus, are not to be construed as limiting the present disclosure.

In addition, descriptions such as "first" and "second" in the present disclosure may be for descriptive purposes only, and cannot be understood as indicating or implying the relative importance or implicitly indicating the number of indicated technical features. Therefore, the features defined as "first" and "second" may explicitly or implicitly include at least one of the features. In the description of the present disclosure, the meaning of "a plurality of" may be at least two, for example, two, and three and so on, unless it may be specifically defined otherwise.

A dispensing control apparatus 1000 according to an embodiment of the present disclosure may include a machine body 100, a first pressure reducing device 200, a first exhaust valve 300, a second exhaust valve 400, a first gas pressure sensor 500 and a control device 600.

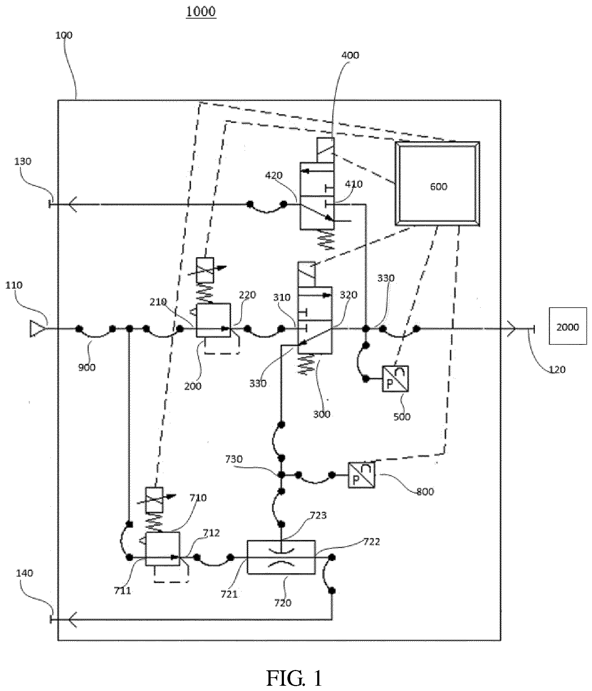

As shown in FIG. 1, the machine body 100 may be provided with a first input interface 110 adapted to be connected to a gas source, a first output interface 120 adapted to be connected to an external glue barrel 2000, and a second output interface 130. The first pressure reducing device 200 may be arranged in the machine body 100, and a gas inlet end 210 of the first pressure reducing device 200 may be connected to the first input interface 110. The first exhaust valve 300 is arranged in the machine body 100, and a gas inlet 310 of the first exhaust valve 300 may be connected to a gas outlet end 220 of the first pressure reducing device 200. The glue discharging principle lies in that when the dispensing control apparatus 1000 is not in operation, the first exhaust valve 300 is in an off state. When it is needed to perform a dispensing operation, a set working gas pressure outputted by the first pressure reducing device 200 flows into a cavity of the glue barrel through the first exhaust valve 300, and glue solution is extruded from a glue solution output end at a tail end of the glue barrel. When the dispensing operation is finished, the first exhaust valve 300 is changed from an on state into the off state.

An inlet 410 of the second exhaust valve 400 may be connected to a gas outlet 320 of the first exhaust valve 300 and the first output interface 120, and an outlet 420 of the second exhaust valve 400 may be connected to the second output interface 130. The first gas pressure sensor 500 may be arranged between the gas outlet 320 of the first exhaust valve 300 and the first output interface 120, so as to acquire a real-time gas pressure in a pipeline 330 connected between the first exhaust valve 300 and the first output interface 120.

The control device 600 may be arranged in the machine body 100, and the control device 600 may be electrically connected to and control the first pressure reducing device 200, the first exhaust valve 300, the second exhaust valve 400 and the first gas pressure sensor 500. The control device 600 may be configured to continuously receive the real-time gas pressure acquired by the first gas pressure sensor 500, process the real-time gas pressure in real time and then extract a characteristic parameter of gas pressure increasing. In this way, in a single dispensing operation, the first gas pressure sensor 500 acquires the increase, stability and decrease of the working gas pressure in real time, and the control device 600 processes the acquired data to form a complete gas pressure waveform curve.

Alternatively, the first gas pressure sensor 500 may be disposed in a working gas pressure output path between the gas outlet of the first exhaust valve 300 and a working gas pressure output port. The gas pressure output port may refer to a gas path joint penetrating through a controller panel, and the gas path joint may be connected to the gas outlet 320 of the first exhaust valve 300 inside the dispensing control apparatus 1000.

The specific working process of the dispensing control apparatus 1000 will be described as follows. Based on a specific volume of the glue barrel 2000 and a specific length of a connecting pipe, the glue barrel 2000 may be connected to the first output interface 120 of the dispensing control apparatus 1000 through the connecting pipe, and the dispensing control apparatus 1000 performs a dispensing operation based on set working parameters (including a glue discharging duration, a working gas pressure and a suck-back gas pressure). Along with the reduction of glue solution in the glue barrel, in the whole working gas pressure waveform acquired by the first gas pressure sensor 500, the gas pressure increasing will gradually become slow, and there is no signification difference in the stabilizing and decreasing of the gas pressure. In this way, key parameters are extracted from the waveform difference in the gas pressure increasing acquired by the first gas pressure sensor 500, and the residual amount of the glue solution in the glue barrel can be calculated by a built-in prediction algorithm, thereby achieving the accurate prediction of the residual amount of the glue solution in the glue barrel.

Based on the accurate prediction of the residual amount of the glue solution, the dispensing control apparatus 1000 may continuously adjust the dispensing parameters based on different residual amounts of the glue solution during the dispensing operation, thereby achieving the extremely high consistency of the glue discharging amount. Alternatively, the dispensing control apparatus 1000 may further enable an alarm function for an insufficient residual amount of the glue solution. When the residual amount of the glue solution is lower than a set alarm threshold, the dispensing control apparatus 1000 may output an alarm signal indicating that the residual amount of the glue solution is insufficient, which prompts the operator to fill or replace the glue solution.

According to the dispensing control apparatus 1000 of the embodiment of the disclosure, by arranging the first gas pressure sensor 500, during the dispensing operation, the first gas pressure sensor 500 may acquire a gas pressure waveform of a single dispensing in real time and extract characteristic parameters of gas pressure increasing, thereby predicting the current residual amount of the glue solution, and working parameters of the dispensing control apparatus may be automatically adjusted, thereby achieving the extremely high consistency in amounts of the dispensed glue solution in the whole dispensing process from the full glue barrel to the empty glue barrel.

It should be noted that, based on the function of the first gas pressure sensor 500 predicting the residual amount of the glue solution in the glue barrel, it is needed to perform extraction and calibration on characteristic parameters of the gas pressure increasing under two working conditions of the full glue barrel and the empty glue barrel before the dispensing operation. Before the dispensing operation, the full glue barrel and the empty glue barrel need to be connected to the first output interface 120 by connecting pipes, the dispensing control apparatus 1000 enters a calibration mode, in which the control device 600 interacts with the first gas pressure sensor 500, the first exhaust valve 300, the first pressure reducing device 200 and the second exhaust valve 400, acquisition of working gas pressures is performed when the full glue barrel (or the empty glue barrel) is connected to obtain a first gas pressure waveform under a working condition of the empty glue barrel and a second gas pressure waveform under a working condition of the full glue barrel, then gas pressure increasing rates are extracted from the acquired waveforms, and extraction and calibration of characteristic parameters of gas pressure increasing for the two working conditions of the full glue barrel and the empty glue barrel are completed respectively.

During the dispensing operation, the control device 600 may interact with the first gas pressure sensor 500, the first exhaust valve 300, the first pressure reducing device 200 and the second exhaust valve 400, so that gas pressure waveforms of a single dispensing may be acquired in real time, characteristic parameters of gas pressure increasing may be extracted, and an accurate prediction of the current residual amount of the glue solution may be achieved by an algorithm built in the control device 600 for predicting the residual amount of the glue solution in a glue barrel.

According to some embodiments of the present disclosure, as shown in FIG. 1, the machine body 100 may be further provided with a third output interface 140. The dispensing control apparatus 1000 may further include a suck-back gas pressure generating device 700. The suck-back gas pressure generating device 700 may include a second pressure reducing device 710 and a vacuum generator 720. A gas inlet 711 of the second pressure reducing device 710 may be connected to the first input interface 110. A vacuum generating port 723 of the vacuum generator 720 may be connected to the gas outlet 320 of the first exhaust valve 300, a gas inlet 721 of the vacuum generator 720 may be connected to a gas outlet 712 of the second pressure reducing device 710, and a gas outlet 722 of the vacuum generator 720 may be connected to the third output interface 140. For example, the second pressure reducing device 710 is an electric proportional valve or an electric air pressure reducing valve.

In the working process, after the dispensing control apparatus 1000 turns on the suck-back function, the control device 600 may interact with the first pressure sensor 500 and the second pressure reducing device 710 to perform feedback adjustment in real time, so as to achieve self-adaptive control of suck-back gas pressure. The self-adaptive control of the suck-back gas pressure may occur in the intermittent time of the dispensing operation, so that a glue outlet at a needle head at a tail end of the glue barrel may be ensured to be free from dripping of the glue solution and mixing of bubbles, thereby ensuring the precise consistency of the glue discharging during the dispensing operation.

As shown in FIG. 1, according to some embodiments of the present disclosure, the pipeline connecting the vacuum generating port 723 of the vacuum generator 720 with the gas outlet 320 of the first exhaust valve 300 may be a gas suction port 730 of the suck-back gas pressure generating device 700. The dispensing control apparatus 1000 may further include a second gas pressure sensor 800. The second gas pressure sensor 800 is connected to the gas suction port 730 of the suck-back gas pressure generating device 700 to acquire a suck-back gas pressure generated by the suck-back gas pressure generating device 700, and is electrically connected to the control device 600, which in turn continuously receives signals acquired by the second gas pressure sensor 800. In other words, the second gas pressure sensor 800 may be disposed at the gas suction port of the suck-back gas pressure generating device between the vacuum generator 720 and the gas outlet of the first exhaust valve 300, and after the suck-back gas pressure is turned on, the second gas pressure sensor 800 may acquire the suck-back gas pressure in real time, and interact with the control device 600 to achieve adaptive feedback control of the suck-back gas pressure.

According to some alternative embodiments of the present disclosure, the first pressure reducing device 200 may be a precise pressure reducing valve, an electric proportional valve or an electric air pressure reducing valve.

In some alternative embodiments, at least one of the first exhaust valve 300 and the second exhaust valve 400 may be a two-position three-way electromagnetic valve, and a flow rate of the second exhaust valve 400 may be greater than that of the first exhaust valve 300. The first exhaust valve 300 is formed as the two-position three-way electromagnetic valve, and the first exhaust valve 300 is a conventional element, which is easy to get.

In an embodiment of the present disclosure, the second exhaust valve 400 is formed as a two-position three-way electromagnetic valve, and the flow rate of the second exhaust valve 400 is greater than the flow rate of the first exhaust valve 300. The second exhaust valve 400 is also a conventional element, which is easy to get.

It should be noted that, joints of a plurality of elements may be connected by hoses 900, which are easy to connect and install.

When the glue discharging operation is finished, the first exhaust valve 300 will be switched from an on state into an off state. At this time, the gas output flow of the first exhaust valve 300 may suddenly drop to zero, so that the gas flow of a load end connected to the gas outlet end of the first exhaust valve 300 may suddenly drop to zero. In this way, the output gas pressure of a first pressure reducing value 230 may overshoot, and the time required for the output gas pressure of the first pressure reducing value 230 to drop from the overshoot to be consistent with the set gas pressure can be reduced by the first pressure reducing device. In the following embodiments of the present disclosure, the first pressure reducing device 200 may be illustrated in details. The dispensing control apparatus according to the embodiments of the disclosure can perform, by adopting such first pressure reducing device, the dispensing operation in a shorter dispensing repeating cycle, thereby improving the dispensing efficiency while ensuring the consistent dispensing precision.

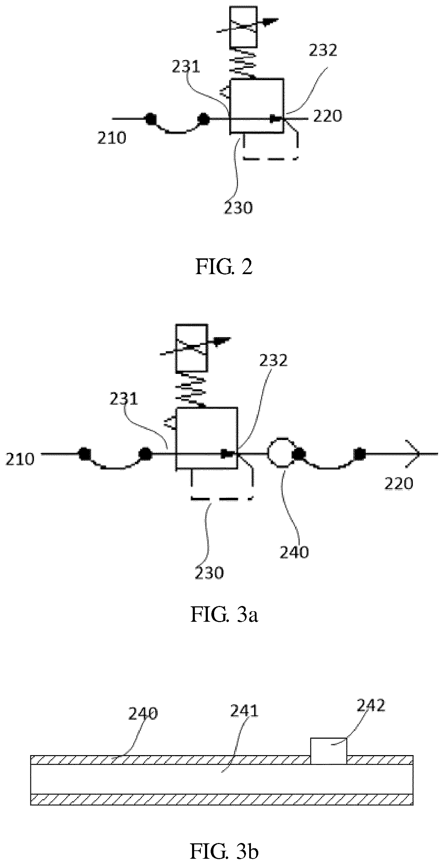

According to some specific embodiments of the present disclosure, as shown in FIG. 2, the first pressure reducing device 200 may include a first pressure reducing valve 230. The first pressure reducing valve 230 may be provided with at least a gas inlet 231 and a gas outlet 232. The gas inlet 231 may form the gas inlet end 210 of the first pressure reducing device 200, and the gas outlet 232 may be connected to the gas inlet 310 of the first exhaust valve 300. The first pressure reducing valve 230 may further include a vent that may be left blank or fitted with a muffler (not shown).

In the dispensing control apparatus 1000 shown in FIG. 1, the first pressure reducing device 200 is exemplified to include only the first pressure reducing valve 230. The present disclosure is not limited thereto.

As shown in FIG. 3a, in other embodiments of the present disclosure, the first pressure reducing device 200 may further include a special-shaped pipe joint 240. As shown in FIG. 3b, the special-shaped pipe joint 240 may be internally provided with a pipe cavity 241 penetrating therethrough along an axial direction thereof. An outer surface of the special-shaped pipe joint 240 may be provided with one or more gas flow channels 242 in communication with the pipe cavity 241. In the dispensing control apparatus according to the embodiments of the present disclosure, the first pressure reducing device 200 operates based on the following principle: when a terminal load connected to the gas outlet end 220, i.e., the glue barrel 2000, does not consume gas or consumes gas at a constant flow rate, the stable output gas pressure of the first pressure reducing device 200 may be consistent with a set gas pressure. When the flow rate of the gas consumed at the load end suddenly reduces (even reducing to zero), which causes the output gas pressure of the first pressure reducing device 200 to be higher than the set gas pressure, a part of the output gas pressure of the first pressure reducing valve 230 may be discharged from the special-shaped pipe joint 240 connected to a gas pressure output port of the first pressure reducing valve 230 at a constant flow rate. When the flow rate at the glue barrel end reduces, the time required for the output gas pressure of the first pressure reducing valve 230 to be reduced from overshoot to be consistent with the set gas pressure may be reduced.

The special-shaped pipe joint 240 may be a product obtained by modifying a gas flow channel based on a standard product in the market or a self-made product obtained by designing and processing, and has a simple structure. Based on the reconstruction implementation of the pipe joint standard product, when the pipe joint standard product is connected to the gas outlet of the first pressure reducing valve 230 in a sealing manner, a hole is formed on a surface of the cavity where the pipe joint standard product is in direct contact with the output gas pressure, and the hole directly or in a bent manner penetrates through the outer surface of the pipe joint standard product to form the special-shaped pipe joint 240. The hole in the outer surface needs to ensure that the special-shaped pipe joint 240 is not covered or shielded after being connected to the first pressure reducing valve 230 in a sealing manner and to a load (in order to ensure that the output gas pressure of the first pressure reducing valve 230 continuously and smoothly leaks from the gas flow channel). A part of the gas pressure outputted from the gas outlet of the first pressure reducing valve 230 may continuously flow out from the gas flow channel at a constant flow rate.

Regardless of whether the load end requires gas flow, it is beneficial for the first pressure reducing valve 230 to remain in a flow output state (i.e., significant feedback regulation) as follows: when the gas pressure flow rate at the load side reduces (even the flow rate reduces to zero), the feedback adjustment of the first pressure reducing valve 230 may not be quickly implemented, and a significant gas pressure overshoot may occur instantaneously, resulting in an overshoot of the output gas pressure. Compared with a standard product of the pressure reducing valve, the gas flow channel continuously consumes the output gas pressure at a constant flow rate, which can directly accelerate the recovery process of the output gas pressure overshoot while reducing the time required for the output gas pressure to be reduced from the overshoot to be consistent with the set gas pressure.

Therefore, compared with the related art, for the dispensing control apparatus according to the embodiments of the present disclosure, since the gas flow channel is provided on the special-shaped pipe joint 240, the first pressure reducing device may recover the output gas pressure of the first pressure reducing device higher than the set gas pressure to be consistent with the set gas pressure in a shorter time, so that an time interval between repeated dispensing operations may be greatly reduced, and a dispensing effect with a consistent height may be achieved.

As an example, the minimum diameter of the gas flow channel 242 is not greater than 1mm, or the minimum cross-sectional area of the gas flow channel 242 is not greater than 1mm². The gas flow channel is used for continuous low flow leakage of high pressure air, but the key of the low flow leakage is that the narrowest part of the gas flow channel cannot be too large. In other words, based on specific conditions at the glue barrel side, different narrowest bore diameters of the gas flow channel may be set, the time required for the output gas pressure to be reduced from overshoot to be consistent with the set gas pressure is tested in detail, and the optimal flow rate of the gas flow channel and the narrowest bore diameter of the gas flow channel suitable for the specific conditions are obtained in the testing process.

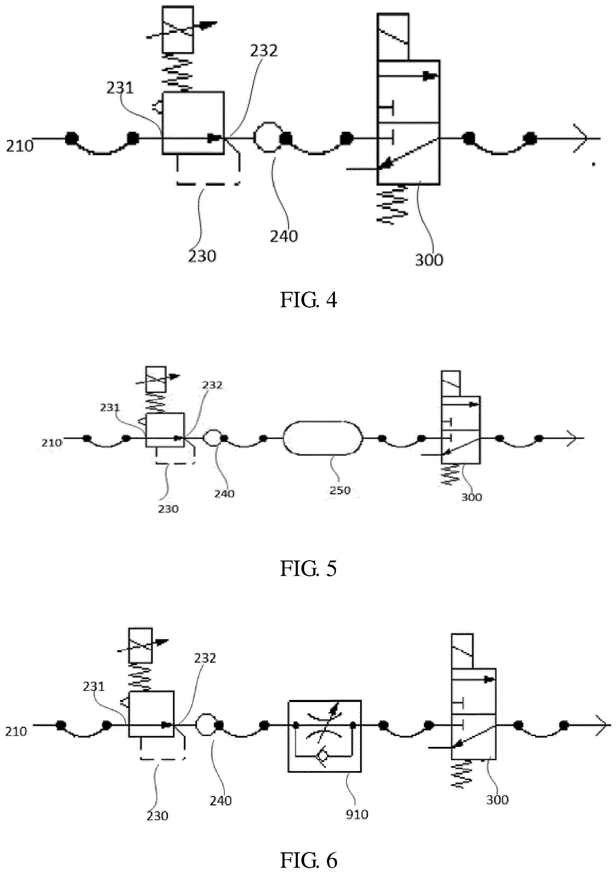

As shown in FIG. 3a and FIG. 4, the special-shaped pipe joint 240 may be connected between the gas outlet of the first pressure reducing valve 230 and the gas inlet of the first exhaust valve 300. The first pressure reducing device including the first pressure reducing valve 230 and the special-shaped pipe joint 240 is simple in structure, and can reduce overshoot of the output gas pressure and recover the output gas pressure higher than the set gas pressure to be consistent with the set gas pressure in a shorter time, especially improving a consistency of the working gas pressure when the dispensing control apparatus 1000 performs quick and repeated dispensing.

According to some embodiments of the present disclosure, as shown in FIG. 5, the dispensing control apparatus 1000 may further include a gas storage tank 250, the gas storage tank 250 is located between the special-shaped pipe joint 240 and the first exhaust valve 300 and is in communication therewith. The gas storage tank 23 may suppress the decrease of the output gas pressure of the first pressure reducing device 200 at the moment when the dispensing control apparatus is starting dispensing, and may suppress the overshoot of the output gas pressure of the first pressure reducing device 200 at the moment when the dispensing control apparatus is finishing dispensing. Thus, the time required for the first pressure reducing device to reduce its output gas pressure from the overshoot to be consistent with the set gas pressure may be further shortened.

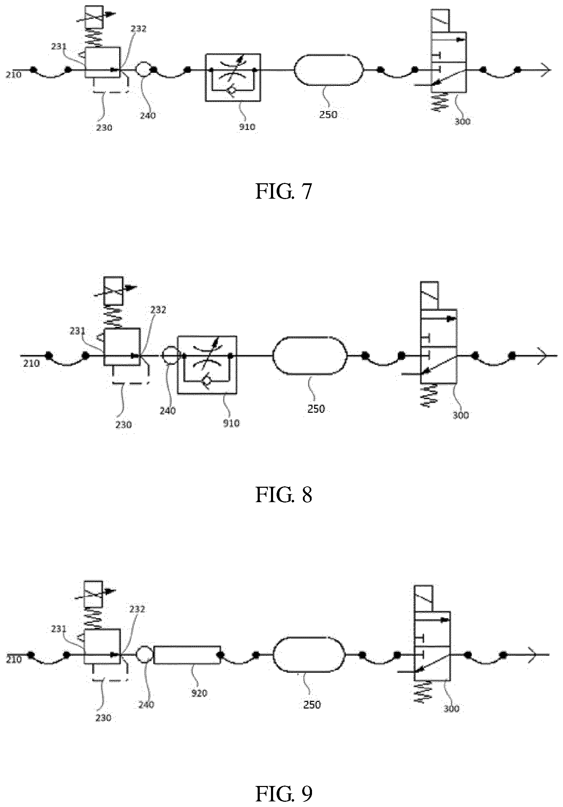

In other embodiments of the present disclosure, the dispensing control apparatus 1000 may further include a speed control valve 910. The speed control valve 910 is located between the special-shaped pipe joint 240 and the first exhaust valve 300 and is in communication therewith. The speed control valve 910 may be used for adjusting a maximum flow output by the first pressure reducing device, and a specific gas flow speed of the speed control valve 910 may be tested and determined based on specific dispensing parameters. Thus, the maximum flow rate output by the first pressure reducing device 200 is adjusted for the specific dispensing parameters, which can further reduce the time required for the first pressure reducing device 200 to reduce its output pressure from the overshoot to be consistent with the set gas pressure. The speed control valve 910 or the gas storage tank 250 may be separately provided between the special-shaped pipe joint 240 and the first exhaust valve 300, as shown in FIG. 6. It is also possible that both the speed control valve 910 and the gas storage tank 250 are dispose between the special-shaped pipe joint 240 and the first exhaust valve 300, as shown in FIG. 7, which can shorten the time required for the first pressure reducing device to reduce its output gas pressure from the overshoot to the set gas pressure to a greater extent.

In some alternative examples, as shown in FIG. 8, the speed control valve 910 and the special-shaped pipe joint 240 may be formed into one piece, which in turn is sealingly hard-connected to the first pressure reducing valve 230. Such integration of components can reduce the number of components and the occupied space.

According to some other embodiments of the present disclosure, the dispensing control apparatus 1000 may further include a variable-diameter pipe 920, which is located between the special-shaped pipe joint 240 and the gas storage tank 250 and is in communication therewith, thereby achieving the same performance and effect as the speed control valve 910. As shown in FIG. 9, the variable-diameter pipe 920 and the special-shaped pipe joint 240 may be formed into one piece.

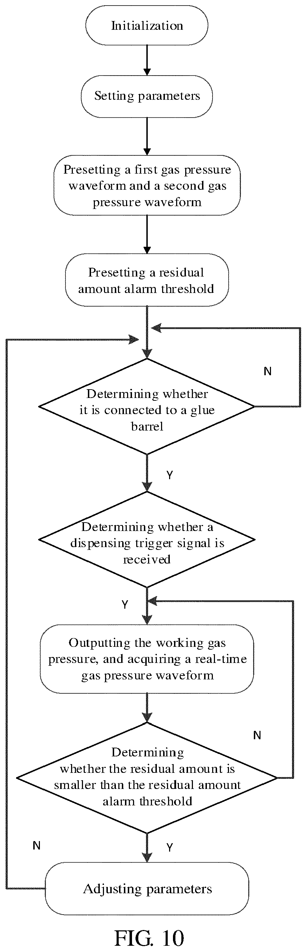

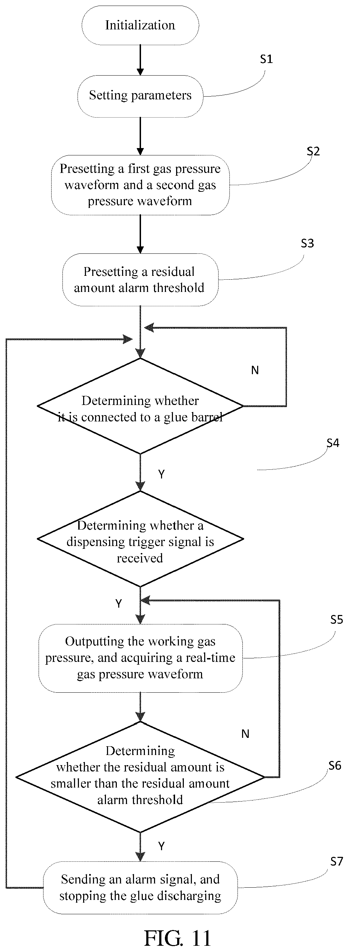

A glue discharging control method of the dispensing control apparatus 1000 according to another embodiment of the present disclosure will be described in detail with reference to FIG. 10 to 12.

In an embodiment, the glue discharging control method of the dispensing control apparatus 1000 includes the following steps.

At S1, a working gas pressure, a suck-back gas pressure and a glue discharging duration are set.

At S2, a first gas pressure waveform when an empty glue barrel is connected to the first output interface 120 and a second gas pressure waveform when a full glue barrel is connected to the first output interface 120 are preset.

At S3, a residual amount alarm threshold is preset.

At S4, it is determined whether the first output interface 120 is connected to a glue barrel to be subjected to dispensing, and whether a dispensing trigger signal is received.

At S5, when the dispensing trigger signal is received, the working gas pressure is output, a real-time gas pressure waveform acquired by the first gas pressure sensor 500 is detected in real time within a glue discharging duration, and a residual amount of the glue in the glue barrel is predicted based on the real-time gas pressure waveform, the first gas pressure waveform and the second gas pressure waveform.

At S6, the working gas pressure, the suck-back gas pressure and the glue discharging duration in the step S1 are adjusted based on the residual amount of the glue, and the method returns to the step S5.

At S7, when the residual amount of the glue in the step S5 is smaller than the residual amount alarm threshold, an alarm signal is sent, the glue discharging is stopped, and the method returns to the step S4.

Therefore, with the glue discharging control method according to the embodiments of the disclosure, the residual amount of glue solution in the glue barrel may be predicted in real time, and the working parameters of the dispensing control apparatus may be automatically adjusted, in such a manner that the extremely high consistency in the glue solution discharging amount of the glue barrel in the whole working process from full glue solution to empty glue solution can be achieved. In addition, the residual amount of the glue solution in the glue barrel may be predicted in real time, the residual amount alarm threshold of the glue solution is set and compared with residual amount of the glue solution, and when the residual amount of the glue solution in the glue barrel is insufficient, an alarm signal is sent to prompt the user, thereby avoiding the dispensing operation in a glue shortage state or even a glue-free state. In addition, based on the self-adaptive feedback control of the suck-back gas pressure, the glue outlet of the needle head at the tail end of the glue barrel may be ensured to be free from dripping of the glue solution and mixing of bubbles, thereby ensuring the precise consistency of the glue discharging during the dispensing operation.

In some embodiments of the present disclosure, in the step S2, detecting each of the first gas pressure waveform and the second gas pressure waveform may include steps as follows.

At S21, it is detected whether the first output interface 120 is connected to the glue barrel to be detected, and whether an execution signal is received.

At S22, the first gas pressure sensor is started, in response to the execution signal being received, to acquire gas pressure waveforms within a preset detection time.

At S23, the corresponding gas pressure waveforms are stored.

From the perspective of an operator, an operation method for glue discharging control by using the dispensing control apparatus according to the embodiments of the disclosure will be explained as follows.

At P1, dispensing parameters are set.

At P2, one of the full glue barrel and the empty glue barrel is connected to the first output interface 120 of the dispensing control apparatus 1000 by the connecting pipe.

At P3, following a prompt of a man-machine interaction menu item of the dispensing control apparatus 1000, the dispensing control apparatus 1000 is operated to perform acquisition of gas pressure waveforms on one of the full glue barrel and the empty glue barrel.

At P4, the other of the empty glue barrel and the full glue barrel is connected to the first output interface 120 of the dispensing control apparatus 1000 by the connecting pipe.

At P5, following a prompt of a man-machine interaction menu item of the dispensing control apparatus 1000, the dispensing control apparatus 1000 is operated to perform acquisition of gas pressure waveforms on the other of the empty glue barrel and the full glue barrel.

At P6, the dispensing control apparatus 1000 automatically executes calculation and storage of calibration parameters based on the acquired gas pressure waveforms of the full glue barrel and the empty glue barrel.

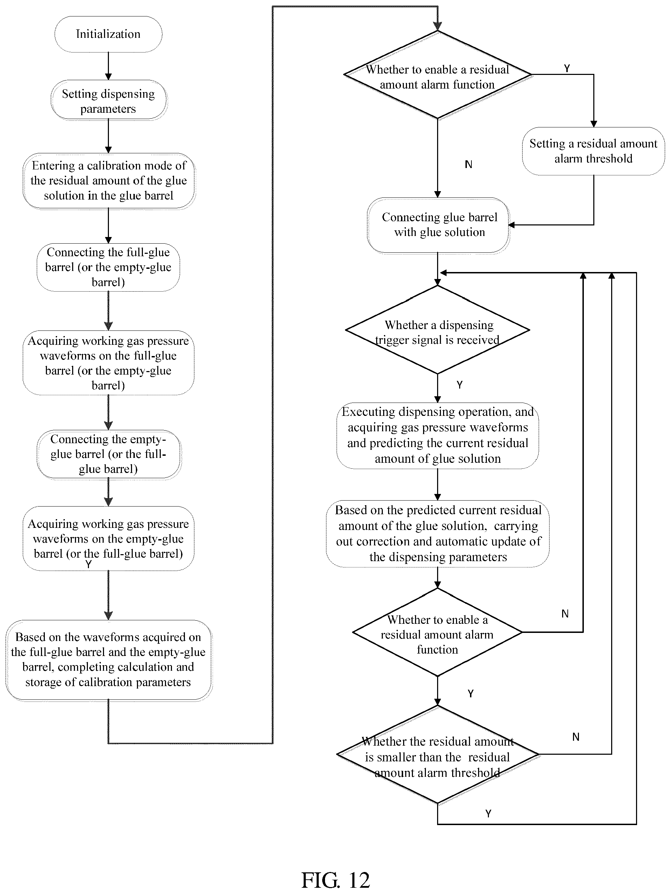

In other words, as shown in FIG. 12, before dispensing operation, the full glue barrel and the empty glue barrel need to be connected to the first output interface 120 by the connecting pipes respectively, the dispensing control apparatus 1000 enters the calibration mode, the control device 600 interacts with the first gas pressure sensor 500, the first exhaust valve 300, the first pressure reducing device 200 and the second exhaust valve 400, acquisition of working gas pressures is performed when the full glue barrel (or the empty glue barrel) is connected, gas pressure increasing rates are extracted from the acquired waveforms, and extraction and calibration of gas pressure increasing characteristic parameters of the full glue barrel and the empty glue barrel working conditions are completed respectively.

Further, the method may further include the following operation steps.

At P7, it is determined whether to enable a residual amount alarm function based on a requirement for the function; and if the function is enabled, a residual amount alarm threshold and related parameters are set through the man-machine interaction menu item of the dispensing control apparatus 1000.

At P8, the glue barrel filled with the glue solution is connected to the first output interface 120 of the dispensing control apparatus 1000 by the connecting pipe.

At P9, the dispensing control apparatus 1000 enters a standby state for dispensing, and waits for a dispensing trigger signal.

At P10, when the dispensing control apparatus 1000 receives the dispensing trigger signal, a dispensing gas pressure is output from the first output interface 120 based on the current dispensing parameters, and acquisition of gas pressure waveforms is performed by the first gas pressure sensor 500, the dispensing control apparatus 1000 then predicts the residual amount of the glue solution in the glue barrel based on the gas pressure waveforms acquired in real time and the stored calibration parameters.

At P11, the dispensing control apparatus 1000 corrects and automatically updates the dispensing parameters based on the predicted residual amount of the glue solution in the glue barrel.

At P12, if the residual amount alarm function is enabled, and the predicted residual amount of the glue solution in the glue bucket is lower than the set glue residual amount alarm threshold, the dispensing control apparatus 1000 generates a low-liquid alarm signal, and then go to step P9.

Specifically, during the dispensing operation, the control device 600 may interact with the first gas pressure sensor 500, the first exhaust valve 300, the first pressure reducing device 200 and the second exhaust valve 400, so that gas pressure waveforms of a single dispensing may be acquired in real time, characteristic parameters of gas pressure increasing may be extracted, and an accurate prediction of the current residual amount of the glue solution may be achieved by an algorithm built in the control device 600 for predicting the residual amount of the glue solution in a glue barrel.

Based on the accurate prediction of the residual amount of the glue solution, the dispensing control apparatus 1000 may continuously adjust the dispensing parameters based on different residual amounts of the glue solution during the dispensing operation, thereby achieving the extremely high consistency of the dispensing amount. The function of alarming the insufficient residual amount of the glue solution may be enabled. When the residual amount of the glue solution is lower than the set glue residual amount alarm threshold, the dispensing control apparatus 1000 may output an alarm signal indicating that the residual amount of the glue solution is insufficient, prompting filling or replacement of the glue solution.

It should be noted that after the dispensing control apparatus 1000 enables the suck-back function, the control device 600 may interact with the first pressure sensor 500 and the second pressure reducing device 710 to perform feedback adjustment in real time, so as to achieve self-adaptive control of the suck-back gas pressure. The self-adaptive control of the suck-back gas pressure may be carried out in the intermittent time of the dispensing operation, so that the glue outlet at the needle head at the tail end of the glue barrel may be ensured to be free from dripping of glue solution and mixing of bubbles, thereby ensuring the precise consistency of the glue discharging during the dispensing operation.

For example, the dispensing parameters may include a dispensing duration, a working gas pressure and a suck-back gas pressure, and are convenient to measure and adjust, thereby facilitating the operation.

According to the present disclosure, the method may predict the residual amount of glue solution in the glue barrel in real time, automatically adjust the working parameters of the dispensing controlling apparatus, and achieve the extremely high consistency of the glue solution discharging amount of the glue barrel in the whole working process from full glue solution to empty glue solution. In addition, the residual amount of the glue solution in the glue barrel may be predicted in real time, and the residual amount alarm threshold of the glue solution is set, so as to prompt that the current residual amount of the glue solution in the glue barrel is insufficient, thereby avoiding the dispensing operation in a glue shortage state or even a glue-free state. In addition, based on the self-adaptive feedback control of the suck-back gas pressure, the glue outlet at the needle head at the tail end of the glue barrel may be ensured to be free from dripping of glue solution and mixing of bubbles, thereby ensuring the precise consistency of the glue discharging during the dispensing operation.

In the description of the specification, references to the description of "one embodiment", "some embodiments", "an example", "a specific example", or "some examples" or the like mean that a particular feature, structure, material, or characteristic described in connection with the embodiment or example is included in at least one embodiment or example of the present disclosure. In the present specification, the schematic representations of the terms used above are not necessarily intended to refer to the same embodiment or example. Moreover, the specific features, structures, materials, or characteristics described may be combined in any suitable manner in any one or more embodiments or examples.

While embodiments of the present disclosure have been shown and described, it will be understood by those of ordinary skill in the art that various changes, modifications, substitutions and variants can be made to the embodiments without departing from the disclosure, the scope of which is defined by the claims.

## Claims

1. A dispensing control apparatus (1000), comprising:
a machine body (100) provided with a first input interface (110) adapted to be connected to a gas source, a first output interface (120) adapted to be connected to an external glue barrel (2000), and a second output interface (130);
a first pressure reducing device (200) arranged in the machine body (100) and comprising a gas inlet end (210) connected to the first input interface (110);
a first exhaust valve (300) arranged in the machine body (100);
a second exhaust valve (400);
a first gas pressure sensor (500) arranged between the gas outlet (320) of the first exhaust valve (300) and the first output interface (120) and configured to acquire a real-time gas pressure in a pipeline (330) connected between the first exhaust valve (300) and the first output interface (120); and
a control device (600) arranged in the machine body (100) and electrically connected to the first pressure reducing device (200), the first exhaust valve (300), the second exhaust valve (400) and the first gas pressure sensor (500), wherein the control device (600) is configured to control the first pressure reducing device (200), the first exhaust valve (300), the second exhaust valve (400) and the first gas pressure sensor (500), and the control device (600) is further configured to continuously receive the real-time gas pressure acquired by the first gas pressure sensor (500), process the real-time gas pressure in real time and extract a characteristic parameter of gas pressure increasing,
**characterized in that**, the first exhaust valve (300) comprises a gas inlet (310) connected to a gas outlet end (220) of the first pressure reducing device (200),
the second exhaust valve (400) comprises an inlet (410) connected to a gas outlet (320) of the first exhaust valve (300) and the first output interface (120), and an outlet (420) connected to the second output interface (130).

2. The dispensing control apparatus (1000) according to claim 1, **characterized in that** the machine body (100) is further provided with a third output interface (140), and the dispensing control apparatus (1000) further comprises a suck-back gas pressure generating device (700) comprising:
a second pressure reducing device (710) comprising a gas inlet (711) connected to the first input interface (110); and
a vacuum generator (720) comprising a vacuum generating port (723) connected to the gas outlet (320) of the first exhaust valve (300), a gas inlet (721) connected to a gas outlet (712) of the second pressure reducing device (710), and a gas outlet (722) connected to the third output interface (140).

3. The dispensing control apparatus (1000) according to claim 2, **characterized in that** the pipeline (330) connecting the vacuum generating port (723) of the vacuum generator (720) with the gas outlet (320) of the first exhaust valve (300) is a gas suction port (730) of the suck-back gas pressure generating device (700), and the dispensing control apparatus (1000) further comprises:
a second gas pressure sensor (800) connected to the gas suction port (730) of the suck-back gas pressure generating device (700) and configured to acquire a suck-back gas pressure generated by the suck-back gas pressure generating device (700), wherein the second gas pressure sensor (800) is electrically connected to the control device (600), and the control device (600) is further configured to continuously receive signals acquired by the second gas pressure sensor (800).

4. The dispensing control apparatus (1000) according to claim 2, **characterized in that** the second pressure reducing device (710) is an electric proportional valve or an electric air pressure reducing valve.

5. The dispensing control apparatus (1000) according to any one of claims 1 to 4, **characterized in that** the first pressure reducing device (200) is a precise pressure reducing valve, an electric proportional valve or an electric air pressure reducing valve; and /or
at least one of the first exhaust valve (300) and the second exhaust valve (400) is a two-position three-way electromagnetic valve, and a flow rate of the second exhaust valve (400) is greater than that of the first exhaust valve (300).

6. The dispensing control apparatus (1000) according to any one of claims 1 to 5, **characterized in that** the first pressure reducing device (200) comprises:
a first pressure reducing valve (230) at least comprising a gas inlet (231) forming the gas inlet end (210) of the first pressure reducing device (200), and a gas outlet (232) connected to the gas inlet (310) of the first exhaust valve (300).

7. The dispensing control apparatus (1000) according to claim 6, **characterized in that** the first pressure reducing device (200) further comprises:
a special-shaped pipe joint (240) internally provided with a pipe cavity (241) penetrating therethrough along an axial direction of the special-shaped pipe joint (240), wherein an outer surface of the special-shaped pipe joint (240) is provided with one or more gas flow channels (242) in communication with the pipe cavity (241), and the special-shaped pipe joint (240) is connected between the gas outlet (232) of the first pressure reducing valve (230) and the gas inlet (310) of the first exhaust valve (300).

8. The dispensing control apparatus (1000) according to claim 7, **characterized in that** the gas flow channel (242) has a minimum diameter smaller than or equal to 1mm, or a minimum cross-sectional area smaller than or equal to 1mm².

9. The dispensing control apparatus (1000) according to claim 7, **characterized in** further comprising:
a gas storage tank (250) located between the special-shaped pipe joint (240) and the first exhaust valve (300) and in communication therewith.

10. The dispensing control apparatus (1000) according to any one of claims 7 to 9, **characterized in** further comprising:
a speed control valve (910) located between the special-shaped pipe joint (240) and the first exhaust valve (300) and in communication therewith, and configured to adjust a maximum flow output by the first pressure reducing device (200).

11. The dispensing control apparatus (1000) according to claim 9, **characterized in** further comprising:
a variable-diameter pipe (920) located between the special-shaped pipe joint (240) and the gas storage tank (250) and in communication therewith.

12. A glue discharging control method of a dispensing control apparatus (1000) according to any one of claims 1 to 11, **characterized in that**, the glue discharging control method comprises:
step S1 of setting a working gas pressure, a suck-back gas pressure and a glue discharging duration;
step S2 of presetting a first gas pressure waveform when an empty glue barrel is connected to the first output interface (120), and a second gas pressure waveform when a full glue barrel is connected to the first output interface (120);
step S3 of presetting a residual amount alarm threshold;
step S4 of determining whether the first output interface (120) is connected to a glue barrel to be subjected to dispensing, and whether a dispensing trigger signal is received;
step S5 of, in response to the dispensing trigger signal being received, outputting the working gas pressure, detecting the real-time gas pressure waveform acquired by the first gas pressure sensor (500) in real time within the glue discharging duration, and predicting a residual amount of glue in the glue barrel based on the real-time gas pressure waveform, the first gas pressure waveform and the second gas pressure waveform;
step S6 of adjusting the working gas pressure, the suck-back gas pressure and the glue discharging duration in the step S1 based on the residual amount of glue, and returning to the step S5; and
step S7 of sending an alarm signal, stopping glue discharging and returning to the step S4, when the residual amount of the glue in the step S5 is smaller than the residual amount alarm threshold.

13. The glue discharging control method according to claim 12, **characterized in that** in the step S2, detecting each of the first gas pressure waveform and the second gas pressure waveform comprises:
step S21 of detecting whether the first output interface (120) is connected to the glue barrel to be detected, and whether an execution signal is received;
step S22 of enabling the first gas pressure sensor (500) to acquire gas pressure waveforms within a preset detection time after receiving the execution signal; and
step S23 of storing the corresponding gas pressure waveforms.

## Patentansprüche

1. Ausgabesteuerungsvorrichtung (1000), umfassend:
einen Maschinenkorpus (100), der mit einer ersten Eingangsschnittstelle (110), die dazu ausgebildet ist, mit einer Gasquelle verbunden zu werden, einer ersten Ausgangsschnittstelle (120), die dazu ausgebildet ist, mit einem externen Klebstoffbehälter (2000) verbunden zu werden, und einer zweiten Ausgangsschnittstelle (130) versehen ist;
eine erste Druckreduziervorrichtung (200), die in dem Maschinenkorpus (100) angeordnet ist und ein Gaseinlassende (210), das mit der ersten Eingangsschnittstelle (110) verbunden ist, umfasst;
ein erstes Auslassventil (300), das in dem Maschinenkorpus (100) angeordnet ist;
ein zweites Auslassventil (400);
einen ersten Gasdrucksensor (500), der zwischen dem Gasauslass (320) des ersten Auslassventils (300) und der ersten Ausgangsschnittstelle (120) angeordnet ist und dazu konfiguriert ist, in einer Rohrleitung (330), die zwischen dem ersten Auslassventil (300) und der ersten Ausgangsschnittstelle (120) verbunden ist, einen Echtzeit-Gasdruck zu erfassen; und
eine Steuerungsvorrichtung (600), die in dem Maschinenkorpus (100) angeordnet ist und mit der ersten Druckreduziervorrichtung (200), dem ersten Auslassventil (300), dem zweiten Auslassventil (400) und dem ersten Gasdrucksensor (500) elektrisch verbunden ist, wobei die Steuerungsvorrichtung (600) dazu konfiguriert ist, die erste Druckreduziervorrichtung (200), das erste Auslassventil (300), das zweite Auslassventil (400) und den ersten Gasdrucksensor (500) zu steuern, und die Steuerungsvorrichtung (600) ferner dazu konfiguriert ist, kontinuierlich den durch den ersten Gasdrucksensor (500) erfassten Echtzeit-Gasdruck zu empfangen, den Echtzeit-Gasdruck in Echtzeit zu verarbeiten und einen charakteristischen Parameter für einen Gasdruckanstieg zu extrahieren,
**dadurch gekennzeichnet, dass** das erste Auslassventil (300) einen Gaseinlass (310), der mit einem Gasauslassende (220) der ersten Druckreduziervorrichtung (200) verbunden ist, umfasst,
das zweite Auslassventil (400) einen Einlass (410), der mit einem Gasauslass (320) des ersten Auslassventils (300) und der ersten Ausgangsschnittstelle (120) verbunden ist, und einen Auslass (420), der mit der zweiten Ausgangsschnittstelle (130) verbunden ist, umfasst.

2. Ausgabesteuerungsvorrichtung (1000) nach Anspruch 1, **dadurch gekennzeichnet, dass** der Maschinenkorpus (100) ferner mit einer dritten Ausgangsschnittstelle (140) versehen ist und die Ausgabesteuerungsvorrichtung (1000) ferner eine Rücksauggasdruckerzeugungsvorrichtung (700) umfasst, umfassend:
eine zweite Druckreduziervorrichtung (710), umfassend einen Gaseinlass (711), der mit der ersten Eingangsschnittstelle (110) verbunden ist; und
einen Vakuumerzeuger (720), umfassend einen Vakuumerzeugungsanschluss (723), der mit dem Gasauslass (320) des ersten Auslassventils (300) verbunden ist, einen Gaseinlass (721), der mit einem Gasauslass (712) der zweiten Druckreduziervorrichtung (710) verbunden ist, und einen Gasauslass (722), der mit der dritten Ausgangsschnittstelle (140) verbunden ist.

3. Ausgabesteuerungsvorrichtung (1000) nach Anspruch 2, **dadurch gekennzeichnet, dass** die Rohrleitung (330), welche den Vakuumerzeugungsanschluss (723) des Vakuumerzeugers (720) mit dem Gasauslass (320) des ersten Auslassventils (300) verbindet, ein Gassauganschluss (730) der Rücksauggasdruckerzeugungsvorrichtung (700) ist und die Ausgabesteuerungsvorrichtung (1000) ferner umfasst:
einen zweiten Gasdrucksensor (800), der mit dem Gassauganschluss (730) der Rücksauggasdruckerzeugungsvorrichtung (700) verbunden ist und dazu konfiguriert ist, einen Rücksauggasdruck, der durch die Rücksauggasdruckerzeugungsvorrichtung (700) erzeugt wird, zu erfassen, wobei der zweite Gasdrucksensor (800) mit der Steuerungsvorrichtung (600) elektrisch verbunden ist und die Steuerungsvorrichtung (600) ferner dazu konfiguriert ist, kontinuierlich Signale zu empfangen, die durch den zweiten Gasdrucksensor (800) erfasst werden.

4. Ausgabesteuerungsvorrichtung (1000) nach Anspruch 2, **dadurch gekennzeichnet, dass** die zweite Druckreduziervorrichtung (710) ein elektrisches Proportionalventil oder ein elektrisches Luftdruckreduzierventil ist.

5. Ausgabesteuerungsvorrichtung (1000) nach einem beliebigen der Ansprüche 1 bis 4, **dadurch gekennzeichnet, dass** die erste Druckreduziervorrichtung (200) ein präzises Druckreduzierventil, ein elektrisches Proportionalventil oder ein elektrisches Luftdruckreduzierventil ist; und/oder
mindestens eines von dem ersten Auslassventil (300) und dem zweiten Auslassventil (400) ein elektromagnetisches Zwei-Stellungs-Drei-Wege-Ventil ist und eine Durchflussrate des zweiten Auslassventils (400) größer als jene des ersten Auslassventils (300) ist.

6. Ausgabesteuerungsvorrichtung (1000) nach einem beliebigen der Ansprüche 1 bis 5, **dadurch gekennzeichnet, dass** die erste Druckreduziervorrichtung (200) umfasst:
ein erstes Druckreduzierventil (230), das mindestens einen Gaseinlass (231), der das Gaseinlassende (210) der ersten Druckreduziervorrichtung (200) bildet, und einen Gasauslass (232), der mit dem Gaseinlass (310) des ersten Auslassventils (300) verbunden ist, umfasst.

7. Ausgabesteuerungsvorrichtung (1000) nach Anspruch 6, **dadurch gekennzeichnet, dass** die erste Druckreduziervorrichtung (200) ferner umfasst:
eine speziell geformte Rohrverbindung (240), die innen durch diese hindurch verlaufend mit einem Rohrhohlraum (241) entlang einer axialen Richtung der speziell geformten Rohrverbindung (240) versehen ist, wobei eine äußere Oberfläche der speziell geformten Rohrverbindung (240) mit einem oder mehreren mit dem Rohrhohlraum (241) kommunizierenden Gasströmungskanälen (242) versehen ist und die speziell geformte Rohrverbindung (240) zwischen dem Gasauslass (232) des ersten Druckreduzierventils (230) und dem Gaseinlass (310) des ersten Auslassventils (300) verbunden ist.

8. Ausgabesteuerungsvorrichtung (1000) nach Anspruch 7, **dadurch gekennzeichnet, dass** der Gasströmungskanal (242) einen Mindestdurchmesser, der kleiner gleich 1 mm, oder eine Mindestquerschnittsfläche, die kleiner gleich 1 mm² ist, aufweist.

9. Ausgabesteuerungsvorrichtung (1000) nach Anspruch 7, **dadurch gekennzeichnet, dass** sie ferner umfasst:
einen Gasspeicherbehälter (250), der zwischen der speziell geformten Rohrverbindung (240) und dem ersten Auslassventil (300) und damit kommunizierend angeordnet ist.

10. Ausgabesteuerungsvorrichtung (1000) nach einem beliebigen der Ansprüche 7 bis 9, **dadurch gekennzeichnet, dass** sie ferner umfassen:
ein Geschwindigkeitssteuerungsventil (910), das zwischen der speziell geformten Rohrverbindung (240) und dem ersten Auslassventil (300) und damit kommunizierend angeordnet ist und dazu konfiguriert ist, einen maximalen Ausgangsdurchfluss durch die erste Druckreduziervorrichtung (200) einzustellen.

11. Ausgabesteuerungsvorrichtung (1000) nach Anspruch 9, **dadurch gekennzeichnet, dass** sie ferner umfasst:
ein Rohr (920) von variablem Durchmesser, das zwischen der speziell geformten Rohrverbindung (240) und dem Gasspeicherbehälter (250) und damit kommunizierend angeordnet ist.

12. Klebstoffausgabesteuerungsverfahren einer Ausgabesteuerungsvorrichtung (1000) nach einem beliebigen der Ansprüche 1 bis 11, **dadurch gekennzeichnet, dass** das Klebstoffausgabesteuerungsverfahren umfasst:
Schritt S1 des Einstellens eines Arbeitsgasdrucks, eines Rücksauggasdrucks und einer Klebstoffausgabedauer;
Schritt S2 des Voreinstellens einer ersten Gasdruckwellenform, wenn ein leerer Klebstoffbehälter mit der ersten Ausgangsschnittstelle (120) verbunden ist, und einer zweiten Gasdruckwellenform, wenn ein voller Klebstoffbehälter mit der ersten Ausgangsschnittstelle (120) verbunden ist;
Schritt S3 des Voreinstellens einer Restmengenwarnschwelle;
Schritt S4 des Bestimmens, ob die erste Ausgangsschnittstelle (120) mit einem Klebstoffbehälter verbunden ist, der einer Ausgabe unterzogen werden soll, und ob ein Ausgabe-Triggersignal empfangen wird;
Schritt S5, in Abhängigkeit davon, dass das Ausgabe-Triggersignal empfangen wird, des Ausgebens des Arbeitsgasdrucks, des Detektierens der durch den ersten Gasdrucksensor (500) erfassten Echtzeit-Gasdruckwellenform in Echtzeit innerhalb der Klebstoffausgabedauer und des Prognostizierens einer Restmenge von Klebstoff in dem Klebstoffbehälter basierend auf der Echtzeit-Gasdruckwellenform, der ersten Gasdruckwellenform und der zweiten Gasdruckwellenform;
Schritt S6 des Einstellens des Arbeitsgasdrucks, des Rücksauggasdrucks und der Klebstoffausgabedauer in Schritt S1 basierend auf der Restmenge von Klebstoff und des Zurückkehrens zu Schritt S5; und
Schritt S7 des Sendens eines Warnsignals, des Anhaltens der Klebstoffausgabe und des Zurückkehrens zu Schritt S4, wenn die Restmenge des Klebstoffs in Schritt S5 kleiner als die Restmengenwarnschwelle ist.

13. Klebstoffausgabesteuerungsverfahren nach Anspruch 12, **dadurch gekennzeichnet, dass** in Schritt S2 das Detektieren von jeder von der ersten Gasdruckwellenform und der zweiten Gasdruckwellenform umfasst:
Schritt S21 des Detektierens, ob die erste Ausgangsschnittstelle (120) mit dem zu detektierenden Klebstoffbehälter verbunden ist und ob ein Ausführungssignal empfangen wird;
Schritt S22 des Aktivierens des ersten Gasdrucksensors (500), um Gasdruckwellenformen innerhalb eines voreingestellten Detektierzeitraums nach Empfangen des Ausführungssignals zu erfassen; und
Schritt S23 des Speicherns der entsprechenden Gasdruckwellenformen.

## Revendications

1. Un appareil de commande de distribution (1000), comprenant :
un corps de machine (100) muni d'une première interface d'admission (110) adaptée de manière à être raccordée à une source de gaz, une première interface de sortie (120) adaptée de manière à être raccordée à un fût de colle externe (2000), et une seconde interface de sortie (130) ;
un premier dispositif réducteur de pression (200) installé dans le corps de la machine (100) et comprenant une extrémité d'admission de gaz (210) raccordée à la première interface d'admission (110),
une première vanne d'échappement (300) installée dans le corps de la machine (100) ;
une seconde vanne d'échappement (400) ;
un premier détecteur de pression de gaz (500) aménagé entre l'orifice de sortie de gaz (320) de la première vanne d'échappement (300) et la première interface de sortie (120) et configuré pour acquérir une pression de gaz en temps réel dans une tuyauterie (330) raccordée entre la première vanne d'échappement (300) et la première interface de sortie (120) ; et
un dispositif de commande (600) aménagé dans le corps de la machine (100) et raccordé électriquement au premier dispositif réducteur de pression (200), à la première vanne d'échappement (300), à la deuxième vanne d'échappement (400) et au premier détecteur de pression de gaz (500), dans lequel le second dispositif de commande (600), est configuré de manière à commander le premier dispositif réducteur de pression (200), la première vanne d'échappement (300), la seconde vanne d'échappement (400) et le premier détecteur de pression de gaz (500), et le dispositif de commande (600) est configuré en outre pour recevoir continuellement la pression de gaz en temps réel acquise par le premier détecteur de pression de gaz (500), pour traiter la pression en temps réel du gaz en temps réel et pour extraire un paramètre caractéristique de la pression de gaz qui qui augmente,
**caractérisé en ce que** la première vanne d'échappement (300) comprend un orifice d'admission de gaz (310) raccordé à une extrémité de sortie de gaz (220) du premier dispositif réducteur de pression (200),
la seconde vanne d'échappement (400) comprend un orifice d'admission (410) raccordé à un orifice de sortie de gaz (320) de la première vanne d'échappement (300) et la première interface de sortie (120), et un orifice de sortie (420) raccordé à la seconde interface de sortie (130).

2. L'appareil de commande de distribution (1000) selon la revendication 1, **caractérisé en ce que** le corps de la machine (100) est muni par ailleurs d'une troisième interface de sortie (140), et l'appareil de commande de distribution (1000) comprend en outre un dispositif de génération de pression de gaz de réaspiration (700) comprenant :
un second dispositif réducteur de pression (710) comprenant un orifice d'admission de gaz (711) raccordé à la première interface d'admission (110), et un générateur de vide (720) comprenant un orifice générateur de vide (723) raccordé à l'orifice de sortie de gaz (320) de la première vanne d'échappement (300), un orifice d'admission de gaz (721) raccordé à un orifice de sortie de gaz (712) du second dispositif réducteur de pression (710) et un orifice d'évacuation de gaz (722) raccordé à la troisième interface de sortie (140).

3. L'appareil de commande de distribution (1000) selon la revendication 2, **caractérisé en ce que** la tuyauterie (330) raccordant l'orifice générateur de vide (723) du générateur de vide (720) avec l'orifice de sortie de gaz (320) de la première vanne d'échappement (300) est un orifice d'aspiration de gaz (730) du dispositif générateur de pression de gaz de réaspiration (700), et l'appareil de commande de distribution (1000) comprend en outre :
un second détecteur de pression de gaz (800) raccordé à l'orifice d'aspiration de gaz (730) du dispositif générateur de pression de gaz de réaspiration (700), et configuré pour acquérir une pression de gaz de réaspiration générée par le dispositif générateur de pression de gaz de réaspiration (700), sur lequel le second détecteur de pression de gaz (800) est raccordé électriquement au dispositif de commande (600), et le dispositif de commande (600) est configuré en outre pour recevoir continuellement des signaux acquis par le second détecteur de pression de gaz (800).

4. L'appareil de commande de distribution (1000) selon la revendication 2, **caractérisé en ce que** le second dispositif réducteur de pression (710) est une vanne proportionnelle électrique ou une vanne réductrice de pression d'air électrique.

5. L'appareil de commande de distribution (1000) selon l'une quelconque des revendication 1 à 4, **caractérisé en ce que** dans le premier dispositif réducteur de pression (200) est une vanne réductrice de pression précise, une vanne proportionnelle électrique ou une vanne réductrice de pression d'air électrique, et/ou au moins l'une entre la première vanne d'échappement (300) et la seconde vanne d'échappement (400) est une vanne électronique à trois voies et à deux positions, et un débit de la seconde vanne d'échappement (400) est une vanne électronique à trois voies et à deux positions, et un débit de la seconde vanne d'échappement (400) est plus élevé que celui de la première vanne d'échappement (300).

6. L'appareil de commande de distribution (1000) selon l'une quelconque des revendication 1 à 5, **caractérisé en ce que** dans le premier dispositif réducteur de pression (200) comprend :
une première vanne réductrice de pression (230) comprenant au moins un orifice d'admission de gaz (231) formant l'extrémité de l'orifice d'admission de gaz (210) du premier dispositif réducteur de pression (200), et un orifice de sortie de gaz (232) raccordé à l'orifice d'admission de gaz (310) de la première vanne d'échappement (300).

7. L'appareil de commande de distribution (1000) selon la revendication 6, **caractérisé en ce que** le premier dispositif réducteur de pression (200) comprend en outre :
Un tube de jonction de forme spéciale (240) muni en son intérieur d'une cavité de tube (241) qui pénètre à travers lui le long d'une direction axiale du tube de jonction de forme spéciale (240), dans lequel une surface extérieure du tube de jonction de forme spéciale (240) est muni d'un ou de plusieurs conduits d'écoulement de gaz (242) en communication avec la cavité de tube (241), et le tube de jonction de forme spéciale (240) est raccordé entre l'orifice d'admission de gaz (232) de la première vanne réduction de pression (230) et l'orifice d'admission de gaz (310) de la première vanne d'échappement (300).

8. L'appareil de commande de distribution (1000) selon la revendication 7, **caractérisé en ce que** le conduit d'écoulement de gaz (242) a un diamètre minimale inférieur ou égal à 1 mm, ou une surface transversale minimale inférieure ou égale à 1 mm².

9. L'appareil de commande de distribution (1000) selon la revendication 7, **caractérisé en ce qu'**il comprend par ailleurs :
un réservoir de stockage de gaz (250) placé entre le tube de jonction de forme spéciale (240) et la première vanne d'échappement (300) et en communication avec lui.

10. L'appareil de commande de distribution (1000) selon l'une quelconque des revendications 7 à 9, **caractérisé en ce qu'**il comprend par ailleurs :
une vanne de régulation de vitesse (910) placée entre le tube de jonction de forme spéciale (240) et la première vanne d'échappement (300) et en communication avec lui, et configuré de manière à ajuster un débit volumique maximal par le premier dispositif réducteur de pression (200).

11. L'appareil de commande de distribution (1000) selon la revendication 9, **caractérisé en ce qu'**il comprend en outre :
un tube de diamètre variable (920) placé entre le tube de jonction de forme spéciale (240) et le réservoir de stockage de gaz (250) et en communication avec lui.

12. Une méthode de régulation de la distribution de colle d'un appareil de commande de distribution (1000) selon l'une quelconque des revendications1 à 11, **caractérisée en ce que** la méthode de régulation de la distribution de colle comprend :
l'étape S1 consistant à régler une pression de gaz de fonctionnement, d'une pression de gaz de réaspiration et d'une durée de distribution de colle ;
l'étape S2 consistant à présenter une première forme d'onde de pression de gaz lorsqu'un fût de colle vide est raccordé à la première interface de sortie (120), et une seconde forme d'onde de pression de gaz lorsqu'un fût de gaz plein est raccordé à 1 première interface de sortie (120),
l'étape S3 consistant à prérégler un seuil d'alarme de quantité résiduelle,
l'étape S4 consistant à déterminer si la première interface de sortie (120) est raccordée à un fût de colle qui doit faire l'objet de la distribution, et si un signal de déclenchement de la distribution a été reçu ;
l'étape S5 consistant à fournir la pression de gaz de fonctionnement, en réponse au signal de déclenchement de la distribution qui a été reçu, à détecter la forme d'onde de pression de gaz en temps réel acquise par le premier détecteur de gaz (500) en temps réel pendant la durée de distribution de colle, et à prédire une quantité résiduelle de colle dans le fût de colle sur la base de la forme d'onde de pression de gaz en temps réel, de la première forme d'onde de pression de gaz et de la seconde forme d'onde de pression de gaz ;
l'étape S6 consistant à ajuster la pression de gaz de fonctionnement, la pression de gaz de réaspiration et la durée de distribution de colle de l'étape S11 sur la base de la quantité résiduelle de colle, et à revenant à l'étape S5, et
l'étape S7 consistant à envoyer un signal d'alarme, à arrêter la distribution de colle et à repasser à l'étape S4, lorsque la quantité résiduelle de la colle de l'étape S5 est plus faible que le seuil d'alarme de la quantité résiduelle.

13. Le procédé de régulation de la distribution de colle selon la revendication 12, **caractérisée en ce que** dans l'étape S2, la détection de chacune de la première forme d'onde de pression de gaz et de la seconde forme d'onde de pression de gaz comprend :
l'étape S21 consistant à détecter si la première interface de sortie (120) est raccordée au fût de gaz qui doit être détecté, et si un signal d'exécution a été reçu ;
l'étape S22 consistant à permettre au premier détecteur de pression de gaz (500) d'acquérir des formes d'ondes de pression de gaz pendant une durée de détection préréglée après avoir reçu le signal d'exécution ; et
l'étape S23 consistant à sauvegarder les formes d'ondes de pression de gaz.
